# EUROPÄISCHE PATENTSCHRIFT

(11) **EP 0 888 463 B1**
(45) Veröffentlichungstag und Bekanntmachung des Hinweises auf die Patenterteilung: **07.05.2003**
(21) Anmeldenummer: 97915308.7
(22) Anmeldetag: 27.02.1997
(51) Int. Cl.: C23C 14/22

(54) **EINRICHTUNG ZUM VAKUUMBESCHICHTEN VON SCHÜTTGUT**
MEANS FOR VACUUM COATING OF BULK MATERIAL
DISPOSITIF DE DEPOT SOUS VIDE SUR DES MATIERES EN VRAC

(30) Priorität: 13.03.1996 DE 19609804
(43) Veröffentlichungstag der Anmeldung: 07.01.1999
(73) Patentinhaber: ROBERT BOSCH GMBH, 70442 Stuttgart (DE)
(72) Erfinder: BURGER, Kurt, D-71292 Friolzheim (DE); VOIGT, Johannes, D-71229 Leonberg (DE); REUTER, Wolfgang, D-61197 Florstadt (DE)
(86) Internationale Anmeldenummer: DE9700344
(87) Internationale Veröffentlichungsnummer: WO97034024

(56) Entgegenhaltungen:
- DE-A- 4 422 688
- DE-C- 4 209 384
- ELECTROCHEMICAL TECHNOLOGY, Bd. 6, Nr. 9-10, September 1968 - Oktober 1968, PRINCETON, NEW JERSEY US, Seiten 374-375, XP002034285 MATTOX AND REBARCHIK: "Sputter cleaning and plating small parts"
- JOURNAL OF PHYSICS E SCIENTIFIC INSTRUMENTS., Bd. 17, Nr. 5, Mai 1984, BRISTOL GB, Seiten 411-416, XP002034284 AHMED AND TEER: "A simple and inexpensive rotating barrel to ion plate small components"

## Beschreibung

### Stand der Technik

Die Erfindung geht *aus von* einer Einrichtung nach der Gattung des Hauptanspruchs, wie sie beispielsweise aus der DD-PS 25 75 54 bekannt ist. Die daraus bekannte Schüttgutbeschichtungseinrichtung umfaßt einen Drehkorb zur Aufnahme von zu beschichtendem Schüttgut sowie eine innerhalb des Drehkorbes angeordnete Plasmatron-Sputterquelle. Letztere ist so nach unten gerichtet, daß sich das zu beschichtende Schüttgut während der Drehbewegung des Drehkorbes stets in ihrem Wirkungsbereich aufhält. An der Innenwand des Drehkorbes befinden sich Leiteinrichtungen, die eine gute Durchmischung des Schüttgutes während der Drehbewegung sicherstellen. Die Einrichtung gestattet die Herstellung von einlagigen metallischen Beschichtungen mit mittlerer Haftfestigkeit. Über Mittel zur Herstellung von Schichten mit bestimmten vorgegebenen Eigenschaften verfügt sie nicht. So sind insbesondere Prozeßschritte zur Erhöhung der Haftfestigkeit einer aufgebrachten Schicht oder die Herstellung von Mehrschichtsystemen nicht aufgezeigt.

### Seite 2

Eine weitere Vakuum-Schüttgutbeschichtungseinrichtung, bei der das zu beschichtende Schüttgut in einem Drehkorb um eine Beschichtungsquelle herum bewegt wird, ist aus der DE-PS 42 09 384 bekannt. Als Beschichtungsquelle dient hier ein Elektronenstrahlverdampfer, der - prinzipbedingt - nach oben wirkt. Zur Erzeugung hochwertiger Schichten befindet sich im Innenraum des Drehkorbes weiterhin eine Plasma- oder Ionenquelle, deren Wirkungsrichtung um etwa 120 Grad gegenüber der des Elektronenstrahlverdampfers gedreht ist. Für die Beschichtung wird der Drehkorb in schnelle Rotation versetzt. Die dabei auftretende Zentrifugalkraft hält das zu beschichtende Schüttgut an der Drehkorbinnenwand. Nacheinander wird das so an der Drehkorbinnenwand fixierte Schüttgut durch die Wirkungsbereiche des Elektronenstrahlverdampfers und der Plasma-/Ionenquelle geführt. Eine im oberen Bereich des Drehkorbes eingreifende Abstreifeinrichtung löst das Schüttgut von der Innenwand und bewirkt dadurch eine ständige Lageänderung des zu beschichtenden Schüttgutes. Mit dieser Einrichtung lassen sich aufgabengemäß Schichten mit unterschiedlichen Eigenschaften herstellen. Allerdings führt die erforderliche schnelle Drehung des Drehkorbes in Verbindung mit dem dadurch entsprechend hart eingreifenden Abstreifprozeß leicht zu Schäden an den zu beschichtenden Bauteilen. Insbesondere bei Bauteilen mit vielen Kanten muß deshalb mit einer hohen Ausschußrate gerechnet werden.

Zur Herbeiführung bestimmter physikalischer Eigenschaften für eine Schicht ist es weiterhin bekannt (DE-OS 42 39 843, DE-OS 43 43 354), den Beschichtungsprozeß unter Zugabe von Reaktivgasen in veränderlichen Konzentrationen durchzuführen.

Bekannte Beschichtungseinrichtungen dieser Art beschränken sich allerdings auf die Beschichtung feststehender Gegenstände und lassen eine Beschichtung von Massengut nicht zu.

Aus DE 42 09 384 Cl ist weiter eine Einrichtung zum Vakuumbeschichten von Massengut bekannt, die durch Plasmaeinwirkung allseitig im Vakuum hochproduktiv beschichtet werden können. Dazu werden in einer Trommel mit sehr hoher Drehzahl die zu beschichtenden Teile durch Fliehkraft an die inneren Wände der Trommel gedrückt und damit fixiert. Mit dieser Einrichtung werden dekorative, harte, verschleißmindernde, elektrisch leitende oder korrosionsschützende Oberflächen erzeugt.

In D. Mattox und F. Rebarchik, Electrochemical Technology, Band 6, Nr. 9-10, Seite 374 - 375, (1968), ist eine Plasmareinigungsreinrichtung beschrieben, bei der auch eine Plasmabeschichtungsquelle zur Beschichtung kleiner Teile vorgesehen ist.

Es ist Aufgabe der vorliegenden Erfindung, eine Beschichtungseinrichtung anzugeben, die es gestattet, Kleinteile als Schüttgut allseitig mit Beschichtungen mit in einem weiten Rahmen vorgebbaren physikalischen Eigenschaften zu versehen.

Diese Aufgabe wird gelöst durch eine Einrichtung mit den im Kennzeichen des Hauptanspruchs angegebenen Merkmalen. Mit Hilfe der erfindungsgemäßen Einrichtung verbessert sich die Wirtschaftlichkeit der Beschichtung von Bauteilen erheblich. Insbesondere gilt dies für die Beschichtung mit in mehreren Prozeßschritten aufzubringenden Schichten und die Herstellung von mehrlagigen Beschichtungen. Die erfindungsgemäße Einrichtung gestattet es, mit einer einzigen Einrichtung eine Vielzahl unterschiedlicher Beschichtungen herzustellen. Aufgrund der langsamen Drehgeschwindigkeit des Drehkorbes ist das Risiko einer Beschädigung der zu beschichtenden Bauteile beim Umwälzen gering. Vorteilhaft für das Erreichen einer hohen Beschichtungsqualität ist die Einbeziehung einer Einrichtung zur Erzeugung eines Reinigungsplasmas in den Drehkorb. Durch Entfernen von Fremdmaterialien vor dem eigentlichen Beschichten gewährleistet sie eine hohe Haftfestigkeit der aufgebrachten Beschichtungen.

Weitere vorteilhafte Ausgestaltungen der erfindungsgemäßen Einrichtung ergeben sich aus den in den Unteransprüchen angegebenen Maßnahmen.

Als Reinigungsplasma dient vorteilhafterweise ein ECR (Elektron-Cyclotron-Resonanz)-Plasma. Zu dessen Erzeugung befinden sich im Innenraum des Drehkorbes eine Magnetanordnung und eine Mikrowelleneinkoppelvorrichtung. Die davon ausgehenden Mikrowellen wirken resonant mit jenen Elektronen im Magnetfeld zusammen, deren Gyrationsfrequenz mit der Mikrowellenfrequenz übereinstimmt. Außerhalb des Drehkorbes, jedoch innerhalb der Vakuumeinrichtung befindet sich vorteilhaft ferner eine Heizung, mittels derer die zu beschichtenden Bauteile vor Beginn des Beschichtungsprozesses ausgegast werden. Der Drehkorb ist ferner zweckmäßig mit einer Spannung beaufschlagt, durch die das zu beschichtende Schüttgut auf ein negatives Potential gebracht wird. Auf diese Weise wird der Fluß positiver Ionen in Richtung auf das Schüttgut vergrößert, wodurch sich die Qualität der erzeugten Schichten sowie die Reinigungs- und die Beschichtungsgeschwindigkeit gezielt beeinflussen lassen. Durch geeignete Blenden läßt sich der Beschichtungsbereich auf die Oberfläche der zu beschichtenden Bauteile einschränken, wobei eine unerwünschte Beschichtung der Drehkorbinnenoberfläche verhindert wird.

Zur Erzielung besonders harter Schichten hat es sich als vorteilhaft erwiesen, die Schichtdeposition bei gleichzeitig brennendem ECR-Plasma durchzuführen.

Unter Bezugnahme auf die Zeichnung wird nachfolgend ein Ausführungsbeispiel der Erfindung näher erläutert.

### Zeichnung

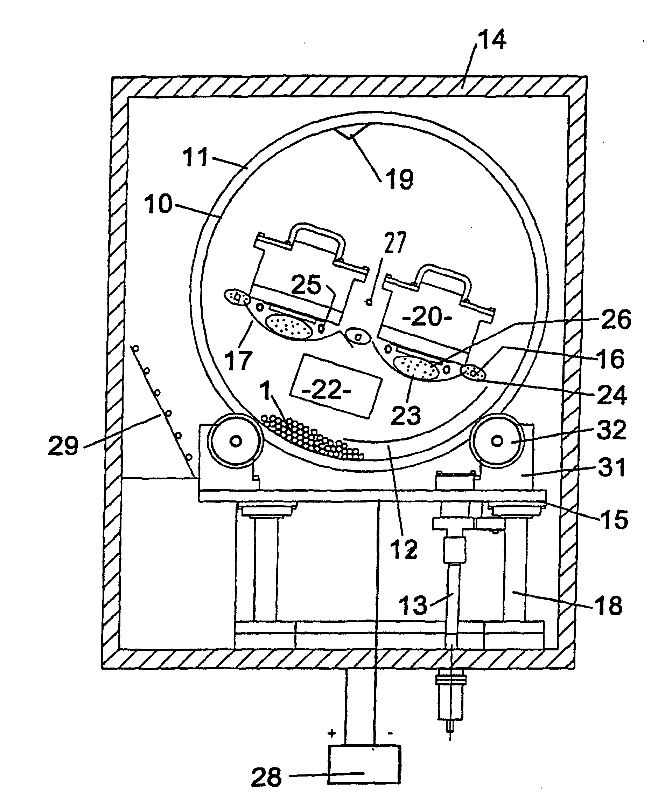

Es zeigen Figur 1 eine Vakuumbeschichtungseinrichtung zur Beschichtung von als Schüttgut vorliegenden Bauelementen, Figur 2 die Struktur einer auf ein Bauelement aufgebrachten Schicht.

Die in Figur 1 dargestellte Beschichtungseinrichtung umfaßt einen Rezipienten 14, worin ein nach links- und rechtsherum drehbarer Drehkorb 10 in Form einer zylindrischen Trommel mit zweckmäßiger Weise konisch zulaufenden Stirnflächen angeordnet ist. Im Innenraum des Drehkorbes 10 befinden sich zwei an sich bekannte Plasmabeschichtungsquellen 20, eine Magnetanordnung 16, sowie eine Mikrowellenkoppeleinrichtung 22. Alle Einbauten 16, 20, 22 sind auf einer gemeinsamen Halterung montiert und als Ganzes um eine in ihrer Mitte liegende Drehachse 27 drehbar. Zusammen mit dem Drehkorb 10 sind sie darüberhinaus aus dem Rezipienten 14 herausnehmbar, beziehungsweise ist der Drehkorb 10 von den Einbauten 16, 20, 22 abziehbar. Der Rezipient 14 weist hierzu nach einer Seite hin einen Vakuumflansch 11 auf, durch den der Drehkorb 10 aus dem Rezipienten 14 bewegt werden kann. An seiner Innenwand weist der Drehkorb 10 Schikanen 19 auf, die zur Umwälzung des zu beschichtenden Schüttgutes 1 dienen.

Der Drehkorb 10 bewegt sich auf einer innerhalb des Rezipienten 14 angeordneten Drehkorblagerung 31, die ihrerseits über eine Stützanordnung 18 am Rezipienten 14 befestigt ist. Die Drehkorblagerung 31 umfaßt eine Grundplatte 15 mit darauf angeordneten Lagerrollen 32, welche den Drehkorb 10 tragen. Grundplatte 15, Lagerrollen 32 und Drehkorb 10 sind dabei gegenüber dem Rezipienten 14, der Stützanordnung 18 sowie gegenüber den im Innenraum des Drehkorbes 10 befindlichen Beschichtungsvorrichtungen 16, 20, 22 elektrisch isoliert. Im Rezipienteninnenraum befindet sich weiterhin eine, ebenfalls gegenüber der Grundplatte 15 elektrisch isolierte Antriebsvorrichtung 13, welche über eine, nicht dargestellte, Kraftübertragungsvorrichtung auf den Drehkorb 10 wirkt, um diesen in eine Drehbewegung zu versetzen. Die Antriebsvorrichtung 13 ist aus dem Rezipienten 14 herausgeführt auf einen, gleichfalls nicht dargestellten, außerhalb des Rezipienten 14 angeordneten Motor. Über die elektrisch leitfähig ausgeführten Lagerrollen 32 und die gleichfalls elektrisch leitfähige Grundplatte 15 ist der Drehkorb 10 mit einem Netzteil 28 verbunden, das sich vorzugsweise außerhalb des Rezipienten befindet. Mit dem Netzteil 28 ist es möglich, den Drehkorb 10 je nach Anwendung unter Spannung zu setzen. Zweckmäßig gestattet das Netzteil 28 das Anlegen elektrischer Gleichspannungspotentiale von 0 bis 1200 V, gepulster uni- bzw. bipolarer Gleichspannungspotentiale mit -10 kV bis +500 V, sowie von Hochfrequenzspannungen im KHz- bis MHz-Bereich mit -3000 V bis +3000 V.

Innerhalb des Rezipienten 14, jedoch außerhalb des Drehkorbes 10 befindet sich weiterhin eine Heizung 29 zur Erwärmung des Schüttgutes 1. Sie ist in Abstimmung auf die Drehgeschwindigkeit des Drehkorbes 10 und auf die Geometrie der zu beschichtenden Bauteile so angeordnet, daß sie sich unter dem sich infolge der Drehkorbbewegung sowie der Bauteilgeometrie in Richtung der Drehbewegung verlagernden Schüttgut 1 befindet. Wird der Drehkorb 10 in beide Drehrichtungen bewegt, ist zweckmäßig symmetrisch zur ersten eine weitere Heizung unter der gegenüberliegenden Drehkorbhälfte vorgesehen, wie in Figur 1 angedeutet.

Den offenen Seiten der Beschichtungsquellen 20 ist jeweils eine bewegliche Abschirmungsplatte 17 zugeordnet, welche bei Bedarf vor die Beschichtungsquelle 20 schwenkbar sind, so daß kein Beschichtungsmaterial von den Beschichtungsquellen 20 auf das zu beschichtende Schüttgut 1 gelangt.

Als Beschichtungsquellen 20 dienen zweckmäßig an sich bekannte Plasmatron-Sputterquellen, wie sie zur PVD-Beschichtung üblich sind. Sie erzeugen an ihrer Austrittsseite ein Kathodenplasma 23, welches Ionen von aus einem Target 26 abgesputterten Material enthält. Zur Steuerung des Ionenflusses in Richtung und Intensität verfügen die Beschichtungsquellen 20 zweckmäßig über geeignete Steuereinrichtungen, wie zum Beispiel Spulen, die unbalancierte Magnetfelder erzeugen. Ebenso können Hilfsanoden vorgesehen sein, welche mit Hilfe positiver Spannungen eine Beeinflussung des Ionenflusses gestatten. Um die Plasmatronkathode und das Target 26 herum ist an jeder Beschichtungsquelle 20 ein Gaseinlaß 25 ausgebildet, durch den Reaktivgase in den Innenraum des Drehkorbes 10 einspeisbar sind. Etwa auf Höhe des von den Plasmatron-Sputterquellen 20 erzeugten Kathodenplasmas 23 sind die Magnetanordnung 16 und die Mikrowelleneinkoppelvorrichtung 22 angeordnet. Sie bilden zusammen eine ECR-Vorrichtung zur Erzeugung eines ECR-Plasmas 24, das sich um die Magnetanordnung 16 herum ausbildet. Zwischen Schüttgut 1 und Beschichtungsquellen 20 mit ECR-Vorrichtung sind, um eine Beschichtung des gesamten Drehkorbes durch sich gleichmäßig im Innenraum verteilendes Beschichtungsmaterial zu vermeiden, geeignete Blenden 18 angeordnet.

Die vorbeschriebene Anlage gestattet eine nach allen Seiten gleichmäßig ausfallende, dreidimensionale Beschichtung von Massenbauteilen, die dabei wie Schüttgut handhabbar sind. Nachfolgend wird der prinzipielle Ablauf eines Beschichtungsvorganges beispielhaft beschrieben.

Für die Beschichtung werden die, nachfolgend einfach als Schüttgut bezeichneten, zu beschichtenden Bauteile in den Drehkorb 10 eingebracht, der Rezipient 14 auf einen Druck von etwa 10⁻⁵ mbar evakuiert.

In einem ersten Bearbeitungsschritt erfolgt nun eine Erwärmung des Schüttgutes 1 mit Hilfe der Heizung 29, um eventuell vorhandene, verdampfbare Fremdstoffe auszugasen.

Nachfolgend wird mit einem definierten Fluß die Zufuhr eines Prozeßgases, in der Regel Argon, begonnen, so daß sich ein typischer Betriebsdruck von 10⁻³ mbar einstellt. Sodann wird der Drehkorb 10 in Bewegung versetzt. Während der Drehung bewirken die Schikanen 16 ein kontinuierliches Umschichten des Schüttgutes 1, so daß bei ausreichender Verweildauer alle Seiten der das Schüttgut bildenden Bauteile gleichmäßig lange in Richtung auf den Drehkorbinnenraum weisen.

An die thermische Vorreinigung schließt sich ein Schritt zur Reinigung der Targets 26 durch Sputtern an. Hierfür werden die Beschichtungsquellen 20 zunächst bei vorgeschwenkten Abschirmplatten 17 betrieben, so daß auf oder innerhalb der Beschichtungsquellen 20 vorhandene Fremdstoffe sich nicht auf dem Schüttgut niederschlagen können. Fremdstoffe bilden sich etwa auf den Targets 26 durch Zersetzung des Prozeßgases, wodurch die Targets 26 bei Prozeßende beispielsweise mit Kohlenstoff belegt sind. Beim öffnen des Rezipienten 14 zur Entnahme des beschichteten Schüttgutes 1 bildet sich mit dem Luftsauerstoff eine Oxidschicht, welche für eine nachfolgende Beschichtung unerwünscht ist. Eventuell vorhandene Fremdstoffe schlagen sich so in der ersten Betriebsphase auf den Abschirmplatten 17 nieder.

Im folgenden Prozeßschritt erfolgt eine Plasmafeinreinigung des Schüttgutes 1 in einem hierzu erzeugten ECR-Plasma 24. Die ECR-Vorrichtung 16, 24 wird dabei, um einen guten Wirkungsgrad zu erreichen, um die Drehachse 27 in Richtung auf die, sich entsprechend der Drehbewegung des Drehkorbes 10 einstellende Lage des Schüttgutes 1 ausgerichtet. Sodann werden über die Mikrowelleneinkoppelvorrichtung 22 Mikrowellen in den Innenraum des Drehkorbes 10 eingekoppelt, welche mit den sich im Magnetfeld der Magnetanordnung 16 bewegenden Ionen und Elektronen wechselwirken. Dabei kommt es zu einer resonanten Wechselwirkung mit denjenigen Elektronen, deren Gyrations-Frequenz mit der Frequenz des Mikrowellenfeldes übereinstimmt. Durch die Resonanzwechselwirkung bildet sich um die Magnetanordnung 16 ein ECR-Plasma 24 aus. Die darin enthaltenen Ionen reinigen das Schüttgut 1 durch die beim Auftreffen entstehende Sputterwirkung. Zur Erhöhung der Reinigungswirkung, sowie zur Verbesserung der Reinigungsgeschwindigkeit wird an den Drehkorb 10 ein elektrisches Potential angelegt, das zu einer elektrisch negativen Aufladung des Schüttgutes 1 führt. Besteht das Schüttgut aus leitenden Bauteilen, wird hierbei an dem Drehkorb 10 in einfacher Weise eine negative Spannung in der Größenordnung von beispielsweise -1000 Volt angelegt. Alternativ kann eine gepulste, höhere Gleichspannung mit bis zu -10 KV angelegt werden. Handelt es sich bei dem Schüttgut 1 um Bauteile aus isolierendem Material, ist an den Drehkorb 10 eine im KHz- bzw. MHz-Bereich liegende, hochfrequente Wechselspannung mit einer Amplitude von vorzugsweise bis zu 3000 Volt anzulegen.

Nach Abschluß der Schüttgutreinigung wird die ECR-Vorrichtung 16, 24 abgeschaltet und beginnt die Schichtabscheidung auf dem Schüttgut 1 mit Hilfe der Beschichtungsquellen 20. Hierfür werden die gereinigten Beschichtungsquellen 20 eingeschaltet und die Abschirmplatten 17 von den Austrittsöffnungen der Beschichtungsquellen 20 weggeschwenkt.

Zur Erhöhung der Beschichtungseffektivität wird das zu beschichtende Schüttgut 1 wiederum durch Anlegen eines geeigneten Potentials an den Drehkorb 10 elektrisch negativ aufgeladen. Im Unterschied zum vorhergehenden Reinigungsschritt, wo die Plasmaionen dazu dienten, auf dem Schüttgut eine Sputterwirkung zu erzielen, soll nunmehr allerdings eine Anlagerung von Plasmaionen an dem Schüttgut 1 erfolgen, gleichzeitig durch Eintrag von kinetischer Ionenenergie eine chemische Aktivierung der Schüttgutoberfläche bewirkt, und die Schüttgutoberfläche außerdem verdichtet werden. Die an den Drehkorb 10 anzulegenden Spannungen sind hieran anzupassen, in der Regel wird eine gegenüber der Reinigungsphase kleinere Amplitude einzustellen sein. Wurde beispielsweise für die Reinigungsphase eine negative Spannung von -1000 Volt angelegt, genügt für das Beschichten eine negative Gleichspannung von -500 Volt. Auf das Schüttgut 1 werden nun in freier Folge unter Zugabe wechselnder, jeweils geeigneter Prozeßgase, wie Ar, N, C₂H₂, CH₄, O₂, H₂ u.s.w. über die Gaseinlässe 25 Schichten mit unterschiedlichen physikalischen Eigenschaften in gewünschter Stärke und Anzahl aufgebracht. Mit Hilfe der Heizung 29 kann dabei die Prozeßtemperatur, die vorzugsweise kleiner als 200° ist, bei Bedarf verändert, insbesondere zeitweise erhöht werden.

Bei Einsatz mehrerer Beschichtungsquellen 20 können die Targets 26 aus verschiedenen Materialien bestehen, wodurch ein entsprechend variabler Schichtaufbau auf dem Schüttgut 1 möglich wird. Beispielsweise kann einer ersten Beschichtungsquelle 20 ein Target 26 zugeordnet sein, mit dem eine Haftschicht auf dem Schüttgut 1 erzeugt wird, einer zweiten Beschichtungsquelle 20 ein Target 26, mit dem eine Funktionsschicht erzeugt wird. Die Beschichtungsquellen 20 sind in diesem Fall zweckmäßig voneneinander weggeneigt, die Beschichtung erfolgt vorzugsweise nacheinander. Der Drehkorb 10 wird dabei entsprechend der jeweils aktiven Beschichtungsquelle 20 links- oder rechtsherum gedreht, so daß sich das Schüttgut 1 jeweils vor der gerade aktiven Beschichtungsquelle 20 befindet. Das Aufbringen der Schichten kann jederzeit unterbrochen werden, um beispielsweise durch Anlegen eines ECR-Plasmas 24 mit Hilfe der ECR-Vorrichtung 16, 22 einen Zwischenreinigungsschritt vorzunehmen. Um Verschmutzungen durch Stoß- oder Reibbewegungen zwischen den das Schüttgut bildenden Bauteilen zu vermeiden, kann es sinnvoll sein, die Drehbewegung des Drehkorbes 10 in Form eines Start-Stop-Betriebs durchzuführen, wobei der Drehkorb 10 in regelmäßigen Abständen angehalten wird.

Mit der vorstehend beschriebenen Anordnung lassen sich in Form von Schüttgut vorliegende Bauelemente, insbesondere mit einer mehrlagigen Beschichtung versehen, wie sie in Figur 2 angedeutet ist. Der grundsätzliche Aufbau solcher mehrlagigen Beschichtungen ist beispielsweise in der DE-OS 43 43 354 für auf Titannitrid basierende Schichtsysteme beschrieben. Er umfaßt eine Funktionsschicht mit einer besonderen, gewünschten Eigenschaft, beispielsweise großer Härte, welche über eine oder mehrere Zwischenschichten 2 bis 4 mit einem Bauelement 1 verbunden ist. Die Zwischenschichten 2 bis 4 dienen dabei je nach Anwendungsfall zur Haftungsvermittlung zwischen Bauelement und Funktionsschicht, zur Herbeiführung einer Stützwirkung, zur Glättung, zur Diffusionshemmung, oder zur Anpassung der mechanischen Eigenschaften von Bauelement und Funktionsschicht, wie etwa der thermischen Ausdehnung, innerer Spannungen, oder der Elastizität. Jede der Teilzwischenschichten 2 bis 4 kann dabei eine andere Funktion erfüllen.

Mit der Anordnung nach Figur 1 konnte eine Vielzahl verschiedenartiger Funktionsschichten realisiert werden. Beispielhaft werden nachfolgend einige aufgeführt.

Es erwies sich, daß mit der erfindungsgemäßen Beschichtungsanordnung insbesondere eine wirtschaftliche Schüttgutbeschichtung mit metallhaltigen Kohlenstoffschichten möglich ist.

Realisiert wurden so unter anderem Funktionsschichten bestehend aus stöchiometrischen und nichtstöchiometrischen Carbiden, Nitriden, Oxiden, Boriden, Sulfiden, Siliziden oder deren Mischungen, wie zum Beispiel MeₓC_{y}, MeₓC_{y}N_{z}, MeₓC_{y}, MeₓO_{y}, MeₓO_{y}N_{z}, MeₓSi_{y}, SiₓN_{y}, SiₓO_{y}. Eine solche Funktionsschicht bestand aus metallhaltigen bzw. metallcarbidhaltigen Kohlenwasserstoffen i-C(Me) bzw. i-C(MeC). wobei die Metallcarbidkristalle in Kohlenstoff- bzw. Kohlenwasserstoffmatrix vorlagen, in die zusätzlich mit einem Anteil von 0 bis 60 Vol.% weitere Elemente, wie Stickstoff, Sauerstoff, Bor, Silicium oder daraus abgeleitete Nitride, Oxide, Boride, Sulfide, Silizide, oder Mischungen davon eingebaut waren.

Realisiert wurde weiterhin eine Funktionsschicht in Form einer metall- oder metallsilizidhaltigen Siliciumschicht, i-Si(Me) bzw. i-Si(MeSi), wobei die Metallsilizidkristalle in Silicium- bzw. Siliciumwasserstoffmatrix vorlagen, in die zusätzlich mit einem Anteil von 0 bis 60 Vol.% weitere Elemente wie Stickstoff, Sauerstoff, Bor, Kohlenstoff oder daraus abgeleitete Nitride, Oxide, Boride, Sulfide, Carbide oder Mischungen davon eingebaut waren.

Eine weitere Funktionsschicht wurde als amorphes Schichtsystem aus Kohlenstoff (a-C) oder Kohlenwasserstoff (a-C:H) mit Zusätzen der Elemente N, O, B, Si, F, Ge mit Anteilen von 0 bis 60 Vol.% realisiert.

In analoger Weise wurde eine Funktionsschicht in Form eines amorphen Schichtsystems auf Silicium (a-Si) oder Siliciumwasserstoff (a-Si:H)-Basis realisiert.

Neben metallhaltigen Kohlenstoffschichten wurde desweiteren eine Funktionsschicht in Form einer Plasmapolymerschicht mit Zugaben von Carbiden, Nitriden, Oxiden, Boriden, Sulfiden, Siliziden oder Mischungen davon mit einem Anteil von 0 bis 50 Vol.% realisiert.

Auf der Basis von MoS₂ wurden weiterhin Funktionsschichten in Form sulfidischer Schichtsysteme realisiert, denen stabilisierende Zugaben zugesetzt wurden.

Die angegebenen Funktionsschichten können in einem mehrlagigen Schichtsystem miteinander kombiniert werden. Im Bezug auf die erzielbare Schichthärte besonders gute Ergebnisse wurden ferner erzielt, wenn die Schichtabscheidung auf dem Schüttgut 1 durch die Beschichtungsquellen 20 bei gleichzeitig brennendem ECR-Plasma 24 erfolgte.

Unter Beibehaltung des Grundkonzeptes ist für die vorstehende Anordnung eine Vielzahl von Varianten denkbar. So kann die Beschichtungsquelle 20 auch als Arc-Kathode oder Hohl-Kathode realisiert, oder können bei Verwendung zweier Beschichtungsquellen, wie in der Figur 4 angedeutet, die Magnetronmagnetfelder gegensinnig oder gleichsinnig ausgerichtet sein. Neben der in der Figur angedeuteten parallelen Ausrichtung der Targets 26 können diese ferner auch voneinander abgewandt oder einander zugewandt ausgerichtet sein. Zur Plasmafeinreinigung des Schüttgutes 1 kann desweiteren ein, etwa durch einen Hohlkathodenbogen erzeugtes Bogenplasma dienen, anstelle einer ECR-Vorrichtung. Eine weitere Alternative zur Verwendung einer ECR-Vorrichtung 16, 24 sieht vor, für die Plasmafeinreinigung gleichfalls die Beschichtungsquellen 20 einzusetzen, wobei diese jedoch mit gegenüber dem eigentlichen Beschichtungsvorgang verringerter Leistung betrieben werden.

## Patentansprüche

1. Einrichtung zum Vakuumbeschichten von Schüttgut (1) mit einem Drehkorb (10) zur Aufnahme des Schüttguts (1), einer innerhalb des Drehkorbs (10) angeordneten Plasmabeschichtungsquelle (20), wobei während des Betriebs der Einrichtung die Drehgeschwindigkeit des Drehkorbs (10). kleiner ist als die zur Erzeugung einer das Schüttgut an der Drehkorbinnenwand fixierenden Fliehkraft erforderlichen Geschwindigkeit, so daß die Teile unter der Wirkung einer Schwerkraft in einem räumlich kleinen Gebiet im unteren Abschnitt des Drehkorbs sich befinden, **dadurch gekennzeichnet, daß** innerhalb des Drehkorbes (10) eine Einrichtung (16, 24) zur ' Plasmareinigung des Schüttguts (1) angeordnet ist und daß die Einrichtung (16, 24) zur Plasmareinigung derart in Bezug auf die Drehachse (27) des Drehkorbes (10) in Richtung auf die Lage des Schüttgutes (1) ausrichtbar ist, daß sich die Wirkungsbereiche von Plasmabeschichtungsquelle (20) und Einrichtung (16, 24)zur Plasmareinigung überlagern.

2. Anordnung nach Anspruch 1, **dadurch gekennzeichnet, daß** die Einrichtung (16, 24) zur Erzeugung eines Reinigungsplasmas eine Mikrowelleneinkoppelvorrichtung (22) und eine Magnetanordnung (16) umfaßt, die derart zusammenwirken, daß sich ein ECR-Plasma ausbildet.

3. Anordnung nach Anspruch 1, **dadurch gekennzeichnet, daß** an der Außenseite des Drehkorbes (10) eine Heizung (29) angeordnet ist.

4. Anordnung nach Anspruch 1, **dadurch gekennzeichnet, daß** an dem Drehkorb (10) eine Spannung anliegt, welche das zu beschichtende Schüttgut (1) auf ein elektrisch negatives Potential bringt.

5. Anordnung nach Anspruch 1, **dadurch gekennzeichnet, daß** sich innerhalb des Drehkorbes (10) ein Gaseinlaß (25) befindet, durch den ein Reaktivgas in den Innenraum des Drehkorbes (10) einbringbar ist.

6. Anordnung nach Anspruch 1, **dadurch gekennzeichnet, daß** der Drehkorb (10) von Beschichtungsquelle (20) und Plasmareinigungsvorrichtung (16, 24) trennbar ist.

7. Anordnung nach Anspruch 1, **dadurch gekennzeichnet, daß** sich im Drehkorb (10) wenigstens zwei Beschichtungsquellen (20) befinden, die zur Abscheidung verschiedener Beschichtungsmaterialien ausgebildet sind.

8. Anordnung nach Anspruch 1, **dadurch gekennzeichnet, daß** sich im Drehkorb (10) wenigstens zwei Beschichtungsquellen (20) befinden, die voneinander so weggeneigt sind, daß sich ihre Wirkungsbereiche nicht überlagern.

9. Anordnung nach Anspruch 1, **gekennzeichnet durch** eine Verwendung zur Beschichtung von Schüttgut (1) mit metall- oder metallcarbidhaltigen Kohlenstoffschichten.

10. Anordnung nach Anspruch 1, **gekennzeichnet durch** eine Verwendung zur Beschichtung von Schüttgut (1) mit metallfreien amorphen Kohlenstoffschichten, die jeweils eines der Elemente N, Si, O, B, Si oder Verbindungen davon untereinander oder mit Kohlenstoff enthalten.

11. Anordnung nach Anspruch 1, **gekennzeichnet durch** eine Verwendung zur Beschichtung von Schüttgut (1) mit Hartstoffschichten, die eines der Elemente C, N, Si, O, B oder Mischungen davon enthalten.

12. Anordnung nach Anspruch 1, **gekennzeichnet durch** eine Verwendung zur Beschichtung von Schüttgut (1) mit Plasmapolymerschichten, denen mit einem Anteil von 0 bis 50 Vol.% Karbide, Oxide, Boride, Sulfide, Silizide oder Mischungen davon zugesetzt sind.

13. Verfahren zum Betrieb einer Anordnung nach Anspruch 1, **dadurch gekennzeichnet, daß** das zu beschichtende Schüttgut (1) vor Aufbringen einer gewünschten Schicht einem Reinigungsplasma ausgesetzt wird, worin es durch einen Sputterätzprozeß feingereinigt wird.

14. Verfahren nach Anspruch 13, **dadurch gekennzeichnet, daß** das zu beschichtende Schüttgut vor Aufbringen einer gewünschten Schicht durch Einwirkung einer Heizung (29) erwärmt wird, um vorhandene Störstoffe auszugasen.

15. Verfahren nach Anspruch 13, **dadurch gekennzeichnet, daß** das zu beschichtende Schüttgut (1) durch Anlegen einer Spannung während der Feinreinigung und/oder während der Beschichtung elektrisch negativ aufgeladen wird.

16. Verfahren zum Betrieb einer Anordnung nach Anspruch 7, **dadurch gekennzeichnet, daß** die Beschichtungsquellen (20) nacheinander zum Beschichten eingesetzt werden.

## Claims

1. Device for the vacuum coating of bulk material (1), having a rotary basket (10) for holding the bulk material (1), a plasma-coating source (20) arranged inside the rotary basket (10), the rotational speed of the rotary basket (10), while the device is operating, being lower than the speed which is required to generate a centrifugal force which fixes the bulk material to the rotary-basket in a wall, so that the parts, under the action of the force of gravity, are located in a spatially small region in the lower section of the rotary basket, **characterized in that** a device (16, 24) for the plasma cleaning of the bulk material (1) is arranged within the rotary basket (10) and **in that** the device (16, 24) for plasma cleaning can be directed towards the position of the bulk material (1) in such a manner, with respect to the axis of rotation (27) of the rotary basket (10), that the areas of action of plasma coating source (20) and device (16, 24) for plasma cleaning are superimposed on one another.

2. Arrangement according to Claim 1, **characterized in that** the device (16, 24) for generating a cleaning plasma comprises a device (22) for introducing microwaves and a magnet arrangement (16), which interact in such a manner that an ECR plasma is formed.

3. Arrangement according to Claim 1, **characterized in that** a heater (29) is arranged on the outer side of the rotary basket (10).

4. Arrangement according to Claim 1, **characterized in that** a voltage is present at the rotary basket (10), applying a negative electrical potential to the bulk material (1) which is to be coated.

5. Arrangement according to Claim 1, **characterized in that** within the rotary basket (10) there is a gas inlet (25), through which a reactive gas can be introduced into the interior of the rotary basket (10).

6. Arrangement according to Claim 1, **characterized in that** the rotary basket (10) can be disconnected from coating source (20) and plasma cleaning device (16, 24).

7. Arrangement according to Claim 1, **characterized in that** in the rotary basket (10) there are at least two coating sources (20) which are designed for the deposition of different coating materials.

8. Arrangement according to Claim 1, **characterized in that** in the rotary basket (10) there are at least two coating sources (20) which are inclined away from one another in such a way that their areas of action are not superimposed on one another.

9. Arrangement according to Claim 1, **characterized by** its use for coating bulk material (1) with metal-or metal carbide-containing carbon layers.

10. Arrangement according to Claim 1, **characterized by** its use for coating bulk material (1) with metal-free, amorphous carbon layers which in each case contain one of the elements N, Si, O, B, Si or compounds thereof with one another or with carbon.

11. Arrangement according to Claim 1, **characterized by** its use for coating bulk material (1) with hard-material layers which contain one of the elements C, N, Si, O, B or mixtures thereof.

12. Arrangement according to Claim 1, **characterized by** its use for coating bulk material (1) with plasma polymer layers, to which carbides, oxides, borides, sulphides, silicides or mixtures thereof are added in an amount of from 0 to 50% by volume.

13. Method for operating an arrangement according to Claim 1, **characterized in that** the bulk material (1) which is to be coated, before a desired layer is applied, is exposed to a cleaning plasma, in which it is finally cleaned using a sputter etching process.

14. Method according to Claim 13, **characterized in that** the bulk material which is to be coated, before a desired layer is applied, is heated by the action of a heater (29) in order to expel in gaseous form impurities which are present.

15. Method according to Claim 13, **characterized in that** the bulk material (1) which is to be coated is electrically negatively charged by the application of a voltage during the fine cleaning and/or during the coating.

16. Method for operating an arrangement according to Claim 7, **characterized in that** the coating sources (20) are used in succession for coating purposes.

## Revendications

1. Installation de revêtement sous vide de produit en vrac (1) comprenant un panier rotatif (10) recevant le produit en vrac (1), une source de revêtement par plasma (20) installée dans le panier rotatif (10), dont pendant le fonctionnement de l'installation, la vitesse de rotation du panier rotatif (10) est inférieure à la vitesse nécessaire pour créer une force centrifuge bloquant le produit en vrac contre la paroi intérieure du panier rotatif, de sorte que les pièces restent dans une petite zone limitée dans l'espace, sous l'effet de la gravité, dans la partie inférieure du panier rotatif,
**caractérisée en ce qu'**
à l'intérieur du panier rotatif (10) il est prévu une installation (16, 24) de nettoyage par plasma du produit en vrac (1), et
l'installation (16, 24) de nettoyage par plasma est dirigée par rapport à l'axe de rotation (27) du panier rotatif (10) en direction de la position du produit en vrac (1), de façon que les zones d'action de la source de revêtement par plasma (20) et celles de l'installation (16, 24) de nettoyage par plasma se superposent.

2. Installation selon la revendication 1,
**caractérisée en ce que**
l'installation (16, 24) générant un plasma de nettoyage comporte un dispositif d'injection d'hyperfréquences (22) et un dispositif électromagnétique (16) coopérant pour développer un plasma ECR.

3. Installation selon la revendication 1,
**caractérisée en ce que**
le côté extérieur du panier rotatif (10) comporte une installation de chauffage (29).

4. Installation selon la revendication 1,
**caractérisée en ce qu'**
on applique une tension au panier rotatif (10) qui met le produit en vrac (1), à revêtir à un potentiel électrique négatif.

5. Installation selon la revendication 1,
**caractérisée en ce qu'**
à l'intérieur du panier rotatif (10), il est prévu une entrée de gaz (25) par laquelle un gaz de réaction est introduit à l'intérieur du panier rotatif (10).

6. Installation selon la revendication 1,
**caractérisée en ce que**
le panier rotatif (10) peut être séparé de la source de revêtement (20) et du dispositif de nettoyage par plasma (16, 24).

7. Installation selon la revendication 1,
**caractérisée en ce qu'**
au moins deux sources de revêtement (20) se trouvant dans le panier rotatif (10), sont réalisées pour déposer différentes matières de revêtement.

8. Installation selon la revendication 1,
**caractérisée en ce qu'**
au moins deux sources de revêtement (20) se trouvent dans le panier rotatif (10), ces sources étant inclinées de manière écartée l'une de l'autre pour que leurs zones d'action ne se chevauchent pas.

9. Installation selon la revendication 1,
**caractérisée par**
son application à un revêtement de produit en vrac (1) avec des couches de carbone contenant du métal ou des carbures métalliques.

10. Installation selon la revendication 1,
**caractérisée par**
son application au revêtement de produit en vrac (1) avec des couches de carbone amorphe sans métal qui contiennent l'un des éléments N, Si, O, B, Si ou des combinaisons de ceux-ci et/ou avec du carbone.

11. Installation selon la revendication 1,
**caractérisée par**
une application au revêtement de produit en vrac (1) avec des couches de matière dure contenant l'un des éléments C, N, Si, O, B ou des mélanges de ceux-ci.

12. Installation selon la revendication 1,
**caractérisée par**
une application au revêtement de produit en vrac (1) avec des couches de polymères au plasma ayant une teneur comprise entre 0 et 50 % en volume de carbures, oxydes, borures, sulfures, siliciures ou des mélanges de ceux-ci.

13. Procédé de mise en oeuvre de l'installation selon la revendication 1,
**caractérisé en ce que**
le produit en vrac (1) à revêtir est exposé à un plasma de nettoyage avant l'application d'une couche souhaitée, puis on procède à un nettoyage fin par un procédé de gravure par pulvérisation.

14. Procédé selon la revendication 13,
**caractérisé en ce que**
le produit en vrac à revêtir est chauffé avant l'application de la couche souhaitée, par l'action d'un moyen de chauffage (29) pour dégazer les produits parasites et présents.

15. Procédé selon la revendication 13,
**caractérisé en ce qu'**
on charge électriquement de manière négative le produit en vrac (1) à revêtir en appliquant une tension pendant le nettoyage fin et/ou pendant le revêtement.

16. Procédé selon la revendication 7,
**caractérisé en ce que**
l'on utilise successivement les sources de revêtement (20) pour réaliser les revêtements.
